# EUROPEAN PATENT APPLICATION

(11) **EP 2 538 464 A2**
(43) Date of publication of application: **26.12.2012**
(21) Application number: 12171256.6
(22) Date of filing: 08.06.2012
(51) Int. Cl.: H01L 35/32

(54) **Thermoelectric conversion units**

(30) Priority: 22.06.2011 JP 2011138651
(71) Applicant: Kabushiki Kaisha Toyota Jidoshokki, Kariya-shi, Aichi 448-8671 (JP)
(72) Inventor: Akiyama, Hirokuni, Kariya-shi, Aichi 448-8671 (JP); Kato, Hirohisa, Kariya-shi,, Aichi 448-8671 (JP); Okuda, Motoaki, Kariya-shi,, Aichi 448-8671 (JP)
(74) Representative: TBK

(57) **Abstract**

Embodiments of the present invention may include a thermoelectric conversion unit (1) having a pair of substrates (2b, 2c) opposing each other, thermoelectric conversion element (2a)s provided between the pair of substrates (2b, 2c), a frame member (4; 6), and a case (3; 5; 7). The frame member (4; 6) may be mounted along an outer peripheral portion of the pair of substrates (2b, 2c). The case (3; 5; 7) may be formed with flow channel (3h, 3i; 5h, 5i; 7h, 7i)s having an opened structure. Opening portions of the flow channel (3h, 3i; 5h, 5i; 7h, 7i)s may be covered with the substrates (2b, 2c). The case (3; 5; 7) may include a peripheral wall portion (3j; 5j; 7a4) configured to cover the outer peripheral portion of the frame member (4; 6). The peripheral wall portion (3j; 5j; 7a4) of the case (3; 5; 7) and the outer peripheral portion of the frame member (4; 6) preferably tightly contact each other to achieve sealing.

## Description

This application claims priority to Japanese patent application serial number 2011-138651, the contents of which are incorporated herein by reference.

Embodiments of the present invention relate to a thermoelectric conversion unit having a thermoelectric conversion element.

A thermoelectric conversion unit described in Japanese Laid-Open Patent Publication 2001-119076 includes a pair of substrates opposing each other, a plurality of thermoelectric conversion elements provided between the pair of substrates, and an insulative resin filled between the plurality of thermoelectric conversion elements between the pair of substrates. The pair of substrates and the thermoelectric conversion elements are integrated by the insulative resin. A thermoelectric conversion unit described in Japanese Laid-Open Patent Publication 2001-4245 includes a case formed with a flow channel having an open structure, a thermoelectric conversion module having thermoelectric conversion elements and configured to cover the opening portion of the flow channel, and a seal member configured to seal a portion between the thermoelectric conversion module and the case.

However, in Japanese Laid-Open Patent Publication 2001-119076, the gaps between the plurality of thermoelectric conversion elements are small, and filling the resin into the gaps is not easy. Therefore, there is a need in the art for a thermoelectric conversion unit having a simple structure in which the thermoelectric conversion elements can be securely held between the pair of substrates. It is also preferred that the case formed with the flow channel can also be mounted securely.

Certain embodiments of the present invention include a thermoelectric conversion unit having a pair of substrates opposing each other, thermoelectric conversion elements provided between the pair of substrates, a frame member, and a case. The frame member may be mounted along an outer peripheral portion of the pair of substrates. The case may be formed with flow channels having an opened structure. Opening portions of the flow channels may be covered with the substrates. The case may include a peripheral wall portion configured to cover the outer peripheral portion of the frame member. The peripheral wall portion of the case and the outer peripheral portion of the frame member are preferably arranged in close proximity such that sealing may occur.

The frame member may hold the pair of the substrate, and the thermoelectric conversion elements via the pair of the substrates. The frame member may be easily configured due to its structure extending along the outer peripheral portions the pair of substrates. The case and the frame member preferably tightly contact with each other and hence can be mounted with each other with stability.

Additional objects, features, and advantages, of the present invention will be readily understood after reading the following detailed description together with the claims and the accompanying drawings, in which:
FIG. 1 is a configuration diagram of a thermoelectric conversion system;
FIG. 2 is a perspective view of a thermoelectric conversion unit;
FIG. 3 is a perspective view of the thermoelectric conversion unit during assembly;
FIG. 4 is a cross-sectional view taken along line IV-IV in FIG. 2;
FIG 5 is a cross-sectional view taken along line V-V in FIG. 2;
FIG. 6 is a perspective view of a thermoelectric conversion unit during assembly;
FIG. 7 is a cross-sectional view taken along line VII-VII in FIG 6;
FIG. 8 is a perspective view of a thermoelectric conversion unit during assembly;
FIG. 9 is a cross-sectional view taken along line IX-IX in FIG. 8;
FIG. 10 is a cross-sectional view corresponding to FIG 5 with the other configuration;
FIG. 11 is a cross-sectional view corresponding to FIG. 5 with the other configuration;
FIG. 12 is a cross-sectional view corresponding to FIG. 5 with the other configuration; and
FIG. 13 is a top view of a thermoelectric conversion unit and a frame.

Each of the additional features and teachings disclosed above and below may be utilized separately or in conjunction with other features and teachings to provide improved thermoelectric conversion units. Representative examples of the present invention, which utilize many of these additional features and teachings both separately and in conjunction with one another, will now be described in detail with reference to the attached drawings. This detailed description is merely intended to teach a person of ordinary skill in the art further details for practicing preferred aspects of the present teachings and is not intended to limit the scope of the invention. Only the claims define the scope of the claimed invention. Therefore, combinations of features and steps disclosed in the following detailed description may not be necessary to practice the invention in the broadest sense, and are instead taught merely to particularly describe representative examples of the invention. Moreover, various features of the representative examples and the dependent claims may be combined in ways that are not specifically enumerated in order to provide additional useful configurations of the present teachings.

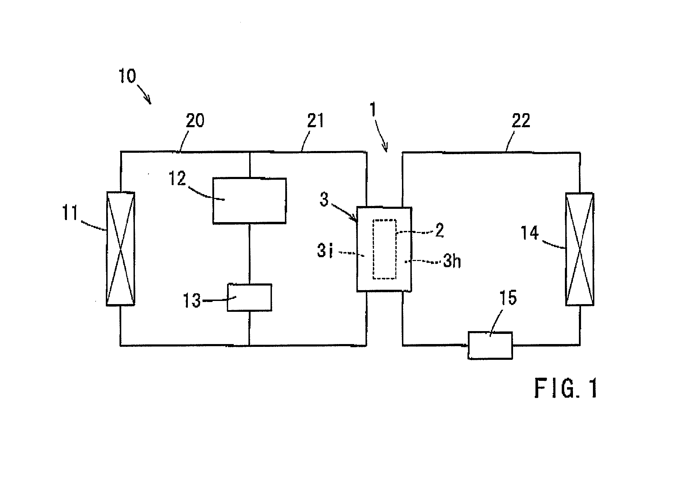

Referring now to FIGS. 1 to 5, an embodiment of the present invention will be described. A heat exchange system 10 is provided, for example, on a vehicle, and as shown in FIG. 1, may include a thermoelectric conversion unit 1, a radiator 11 and an indoor heat exchanger 14. The radiator 11 may be connected to an engine 12 of the vehicle by piping 20. An outdoor heat medium (coolant liquid) may circulate between the engine 12 and the radiator 11 by a pump 13 provided at a midpoint of the piping 20. The outdoor heat medium receives heat from the engine 12 and radiates the heat from the radiator 11 to the outside.

The thermoelectric conversion unit 1 may be connected to the radiator 11 by piping 21 connected to the piping 20 as shown in FIG. 1, and may be connected to the radiator 11 in parallel to the engine 12. The outdoor heat medium is cooled upon reception of cold from the thermoelectric conversion unit 1 via the piping 20, 21. Therefore, the outdoor heat medium can be cooled not only by the radiator 11 but also by the thermoelectric conversion unit 1.

The thermoelectric conversion unit 1 may be connected to the indoor heat exchanger 14 by piping 22 as shown in FIG 1. An indoor heat medium (coolant liquid) may circulate between the thermoelectric conversion unit 1 and the indoor heat exchanger 14 by a pump 15 provided at a midpoint of the piping 22. The indoor heat medium may receive heat from the thermoelectric conversion unit 1, and radiate the heat to indoor air from the indoor heat exchanger 14. Therefore, the indoor air can be heated by the indoor heat exchanger 14.

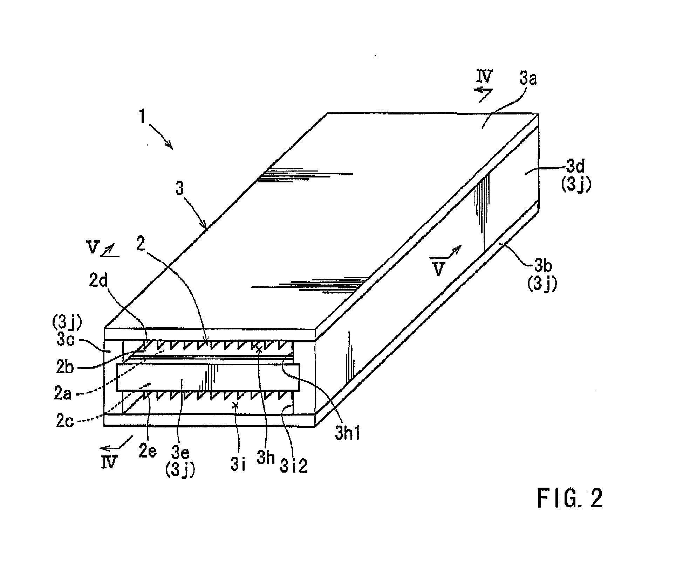

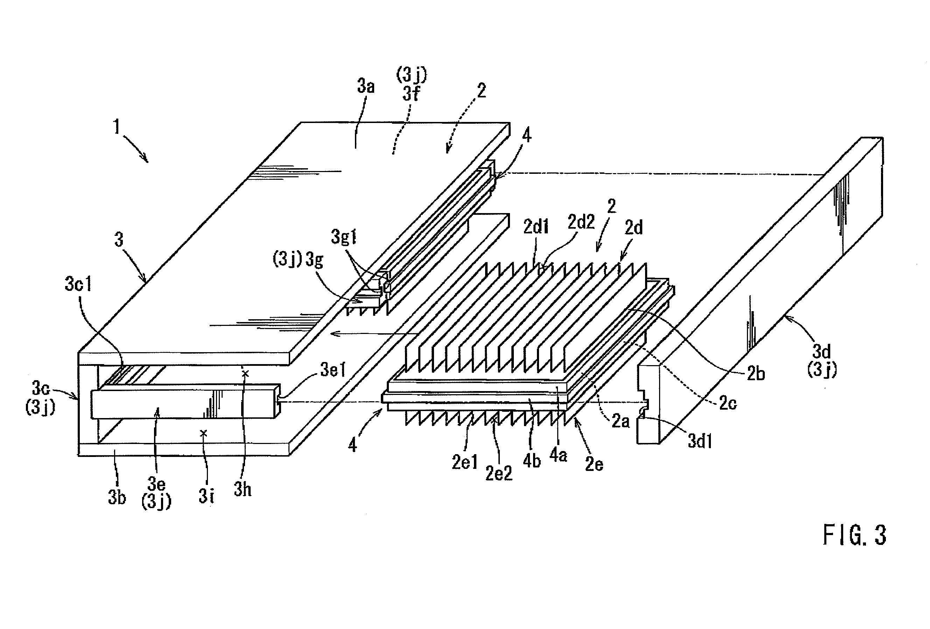

The thermoelectric conversion unit 1 includes a case 3 and preferably a plurality (two, for example) of thermoelectric conversion modules 2 as shown in FIGS. 2 and 3. The case 3 preferably has a cylindrical shape and an internal space formed in the case 3. The case 3 preferably includes a top panel 3a, a bottom panel 3b, and side panels 3c and 3d. A front panel 3e is preferably provided between front portions of the side panels 3c and 3d, a rear panel 3f is preferably provided between rear portions of the side panels 3c and 3d, and a center panel 3g is preferably provided between center portions of the side panels 3c and 3d.

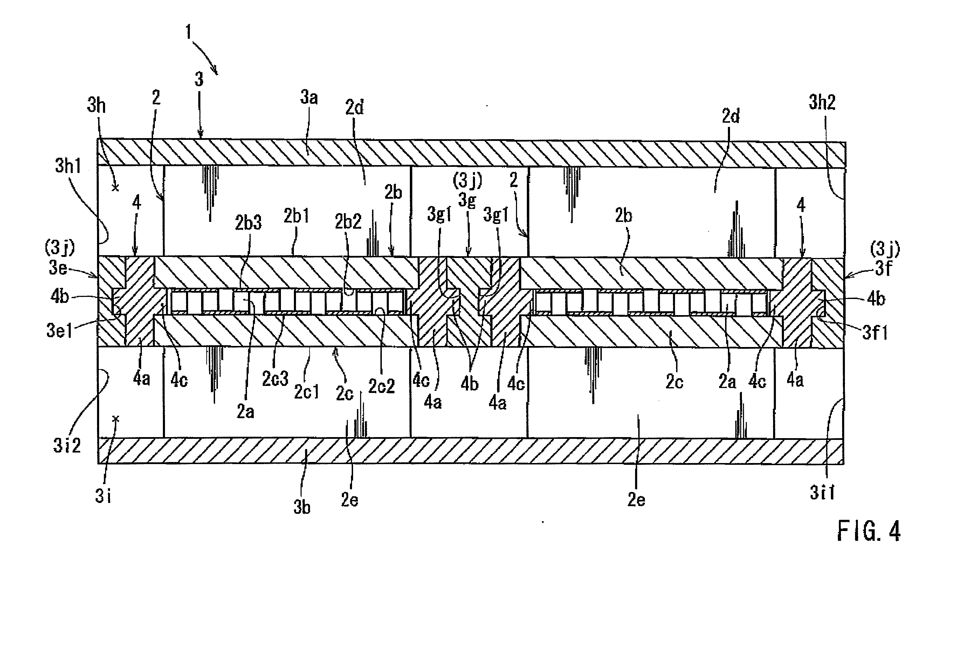

As shown in FIGS. 3 and 4, the front panel 3e, the rear panel 3f, and the center panel 3g are preferably positioned between the top panel 3a and the bottom panel 3b. They are preferably positioned so that two flow channels 3h and 3i can be formed between the top panel 3a and the bottom panel 3b. Inner side surfaces of the front panel 3e and the rear panel 3fmay be formed with depressed portions 3el and 3fl. The depressed portions 3el and 3fl may be formed over the entire length of the front panel 3e and the rear panel 3f in the longitudinal direction. The center panel 3g preferably has both inner side surfaces opposing the front panel 3e and the rear panel 3f. Depressed portions 3gl may be formed on the both inner side surfaces. The depressed portions 3gl may be formed over the entire length of the center panel 3g in the longitudinal direction.

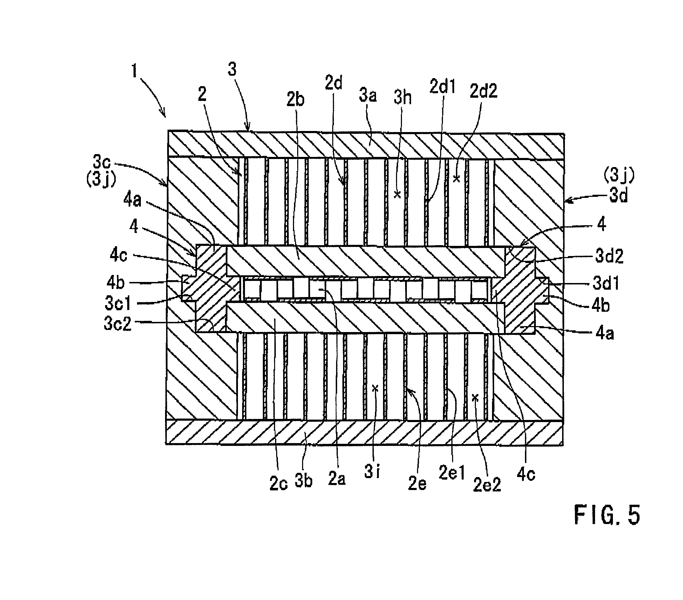

As shown in FIG. 5, large depressed portions 3c2 and 3d2 and depressed portions 3c1 and 3d1 are preferably formed on the inner peripheral surfaces of the side panels 3c and 3d. The large depressed portions 3c2 and 3d2 are preferably formed at substantially the centers in height of the side panels 3c and 3d, and are formed over the entire length of the side panels 3c and 3d in the longitudinal direction. The depressed portions 3c1 and 3dl are preferably formed so as to be depressed on bottom surfaces of the large depressed portions 3c2 and 3d2. The depressed portions 3c1 and 3d1 are preferably formed over the entire length of the side panels 3c and 3d in the longitudinal direction. As shown in FIG. 3 the thermoelectric conversion module 2 is preferably inserted into the case 3 in a state in which the side panel 3d is removed.

As shown in FIGS. 4 and 5, the thermoelectric conversion module 2 preferably includes thermoelectric conversion elements 2a, substrates 2b and 2c, and fins 2d and 2e. The thermoelectric conversion elements (Peltier elements) 2a are preferably formed of different metals, conductors, or semiconductors. The thermoelectric conversion element 2a achieves a Peltier effect by using a DC electricity. Of the two heating surfaces, at least one heating surface absorbs heat as a heat-absorbing portion, while the at least other one radiates heat as a heat-radiating portion. A plurality of thermoelectric conversion elements 2a may be provided between the substrates 2b and 2c. The plurality of thermoelectric conversion elements 2a are preferably arranged in a plurality of rows in the vertically and laterally planar directions with respect to the substrates 2b and 2c.

The substrates 2b and 2c are preferably formed into a panel shape as shown in FIG. 4, and are made from an insulative material. The substrates 2b and 2c include inner surfaces 2b2 and 2c2 opposing each other and outer surfaces 2b1 and 2c1 positioned on the back sides of the inner surfaces 2b2 and 2c2. The inner surfaces 2b2 and 2c2 are preferably provided with electrodes 2b3 and 2c3 arranged in a plurality of rows in the vertical and lateral directions. The electrodes 2b3 and 2c3 are preferably made from a conductive material, and the thermoelectric conversion elements 2a may be soldered on the electrodes 2b3 and 2c3.

The substrates 2b and 2c may partition an internal space of the case 3 by being inserted into the case 3 as shown in FIGS. 3 and 4. The internal space of the case 3 may be partitioned into the first flow channel 3h by the first substrate 2b and the internal space of the case 3 may be partitioned into the second flow channel 3i by the second substrate 2c. In other words, the first flow channel 3h and the second flow channel 3i are formed having an opened structure in the interior of the case 3. An opening portion of the first flow channel 3h may be covered with the first substrate 2b and an opening portion of the second flow channel 3i may be covered with the second substrate 2c. The first flow channel 3h and the second flow channel 3i include inlet ports 3h1 and 3il at one end portion of the case 3 and exits 3h2 and 3i2 at the other end of the case 3.

As shown in FIGS. 3 and 5, the fins 2d and 2e are preferably provided on the outer surfaces 2b1 and 2c1 of the substrates 2b and 2c. The fins 2d and 2e project toward the flow channels 3h and 3i from the substrates 2b and 2c. The fins 2d and 2e include a plurality of plate portions 2dl and 2el arranged side by side and are formed with gaps 2d2 and 2e2 between the plate portions 2dl and 2el. The gaps 2d2 and 2e2 preferably expand in the direction of flow in the flow channels 3h and 3i so as not to block the flow channels 3h and 3i.

A frame member 4 may be mounted on outer peripheral portions of the substrates 2b and 2c as shown in FIGS. 3 to 5. The frame member 4 is preferably made of a rubber or a resin having a large elastic deformation potential. The frame member 4 integrally includes a frame body 4a, a projecting portion 4b, and an inner projecting portion 4c. An inner peripheral portion of the frame body 4a preferably has an annular shape and preferably comes into tight contact with the entire outer peripheries of the substrates 2b and 2c. Accordingly, the frame body 4a preferably seals a portion between the outer peripheral portions of the substrates 2b and 2c and protects the thermoelectric conversion elements 2a from the heat medium or the outside air.

The inner projecting portion 4c may project from the frame body 4a to between the substrates 2b and 2c. The inner projecting portion 4c may project from the entire circumference of an inner peripheral surface of the frame body 4a. The inner projecting portion 4c is preferably in close proximity to or abuts the inner surfaces 2b2 and 2c2 of the substrates 2b and 2c. Accordingly, the inner projecting portion 4c preferably restricts the substrates 2b and 2c from getting close and the thermoelectric conversion elements 2a from collapsing.

The projecting portion 4b may project outward from the frame body 4a as shown in FIGS. 3 and 4. The projecting portion 4b preferably projects from the entire periphery of an outer peripheral surface of the frame body 4a. The projecting portion 4b may be inserted into the depressed portions 3el to 3gl from the sides of the case 3 from which the side panel 3d is removed. The projecting portion 4b may be inserted into the case 3 while being guided to the depressed portions 3el to 3gl. The frame member 4 and the thermoelectric conversion module 2 are preferably inserted into the case 3.

As shown in FIGS 4 and 5, the projecting portion 4b may also be inserted into the depressed portions 3c1 and 3d1 of the side panels 3c and 3d. An outer peripheral portion of the frame member 4 preferably opposes a peripheral wall portion 3j (the side panels 3c and 3d, the front panel 3e, the rear panel 3f, and the center panel 3g) of the case 3 and preferably comes into tight contact with the entire periphery with respect to the peripheral wall portion 3j. Accordingly, the frame member 4 may cooperate with the substrates 2b and 2c, and can partition the internal space of the case 3 into the flow channels 3h and 3i.

When manufacturing the thermoelectric conversion unit 1, the frame member 4 may be mounted on the thermoelectric conversion module 2 as shown in FIG. 3. The thermoelectric conversion module 2 can be slid and inserted into the case 3 together with the frame member 4. As shown in FIG. 2, the side panel 3d of the case 3 may be mounted on a case body. A converter, not illustrated, may be electrically connected to the thermoelectric conversion unit 1. The converter supplies a DC electricity to the thermoelectric conversion unit 1, and the DC electricity flows in series through the plurality of thermoelectric conversion elements 2a by the electrodes 2b3 and 2c3. With the supply of the electric current, the thermoelectric conversion elements 2a can absorb heat via the second substrate 2c and the second fin 2e and radiate the heat via the first substrate 2b and the first fin 2d_{.}

The second flow channel 3i of the thermoelectric conversion unit 1 may be connected to the piping 21 as shown in FIG. 1. The outdoor heat medium is supplied to the second flow channel 3i by the pump 13 via the piping 20 and 21, The outdoor heat medium is supplied from the inlet port 3i1 to the second flow channel 3i as shown in FIG. 4. The outdoor heat medium preferably flows in the second flow channel 3i, is cooled by from the second substrate 2c and the second fin 2e, and is discharged from the exit 3i2 to the outside of the second flow channel 3i.

The first flow channel 3h of the thermoelectric conversion unit 1 is preferably connected to the piping 22 as shown in FIG 1. The indoor heat medium is supplied to the first flow channel 3h by the pump 15 via the piping 22. The indoor heat medium flows in the first flow channel 3h from the inlet port 3hl as shown in FIG. 4, thereby receiving heat from the first substrate 2b and the first fin 2d. The indoor heat medium is discharged from the exit 3h2 to the outside of the first flow channel 3h, and flows in the indoor heat exchanger 14 shown in FIG 1. The indoor heat exchanger 14 discharges the heat to the air in the interior of the chamber.

As described above, the thermoelectric conversion unit 1 preferably includes the pair of substrates 2b and 2c opposing each other, the thermoelectric conversion elements 2a provided between the pair of substrates 2b and 2c, the frame member 4 and the case 3 as shown in FIGS. 4 and 5. The frame member 4 may be mounted on and along the outer peripheral portion of the pair of substrates 2b and 2c. The case 3 is preferably formed with the flow channels 3h and 3i having an opened structure, and whose opening portions of the flow channels 3h and 3i are covered with the substrates 2b and 2c. The case 3 includes the peripheral wall portion 3j (3c to 3g) configured to cover the outer peripheral portion of the frame member 4. The peripheral wall portion 3j of the case 3 and the outer peripheral portion of the frame member 4 preferably come into tight contact with each other to achieve sealing.

The frame member 4 preferably holds the pair of the substrates 2b and 2c. The pair of substrates 2b and 2c hold the thermoelectric conversion elements 2a. The frame member 4 may be easily configured due to its structure extending along the outer peripheral portions of the pair of substrates 2b and 2c. The case 3 and the frame member 4 may be brought into tight contact with each other, and hence be securely mounted with each other.

The frame member 4 may include an inner peripheral portion contacting the circumferences of the respective outer peripheral portions of the pair of substrates 2b and 2c and/or the outer peripheral portion which contacts the circumference of the peripheral wall portion 3j of the case 3 as shown in FIGS. 4 and 5. Therefore, the inner peripheral portion of the frame member 4 can protect the thermoelectric conversion elements 2a from the heat medium or the outside air through sealing a portion between the pair of substrates 2b and 2c. The frame member 4 is preferably positioned between the case 3 and the substrates 2b and 2c and seals a portion between the case 3 and the substrates 2b and 2c. Therefore, the frame member 4 forms the flow channels 3h and 3i in cooperation with the substrates 2b and 2c.

As shown in FIGS. 4 and 5, the peripheral wall portion 3j of the case 3 may be formed with the depressed portions 3c1 to 3g1. The frame member 4 preferably has a projecting portion 4b which can be inserted into the depressed portions 3c1 to 3g1. The case 3 and the frame member 4 can be securely mounted using the depressed portions 3c1 to 3gl and the projecting portion 4b.

The case 3 may be provided with a tubular member formed with opening portions at both ends thereof as shown in FIGS. 3 and 4. The depressed portions 3c1 to 3g1 extending in the axial direction of the tubular member may be formed on the inner peripheral portion of the case 3. The depressed portions 3c1 to 3g1 preferably reach both opening portions of the case 3, Therefore, by using the depressed portions 3e1 to 3g1 and the projecting portion 4b, the frame member 4 and the case 3 can be mounted using a sliding movement.

As shown in FIGS. 3 and 4 an internal space configured to store a pair of substrates 2b and 2c and the frame member 4 may be formed in the case 3. The internal space includes a first flow channel 3h partitioned by the first substrate 2b and the frame member 4, and a second flow channel 3i partitioned by the second substrate 2c and the frame member 4. Therefore, the frame member 4 forms the two flow channels 3h and 3i in the case 3 through use of the substrates 2b and 2c,

While the embodiments of invention have been described with reference to specific configurations, it will be apparent to those skilled in the art that many alternatives, modifications and variations may be made without departing from the scope of the present invention. Accordingly, embodiments of the present invention are intended to embrace all such alternatives, modifications and variations that may fall within the spirit and scope of the appended claims. For examples, embodiments of the present invention should not be limited to the representative configurations, but may be modified, for example, as described below.

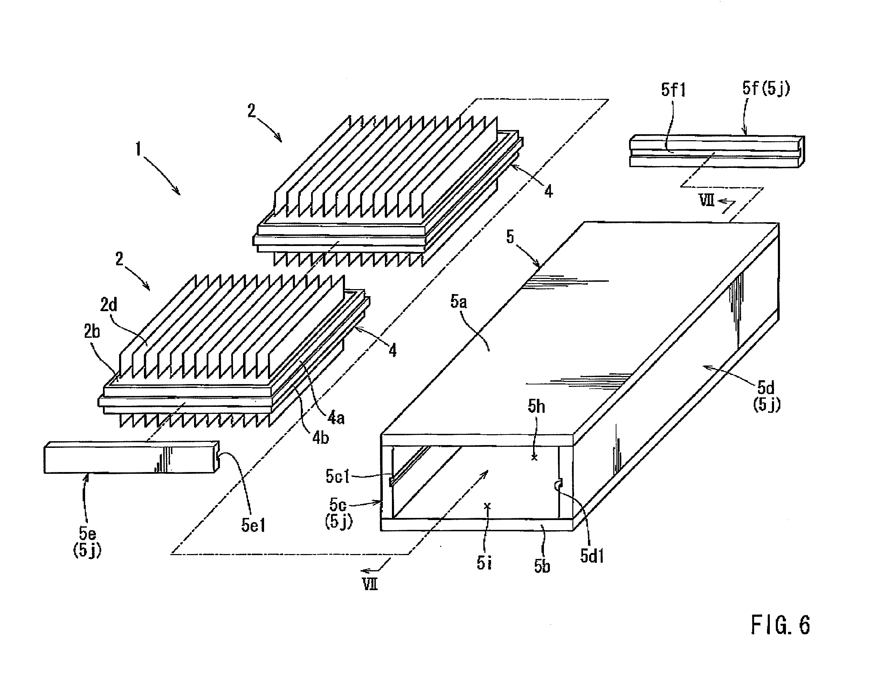

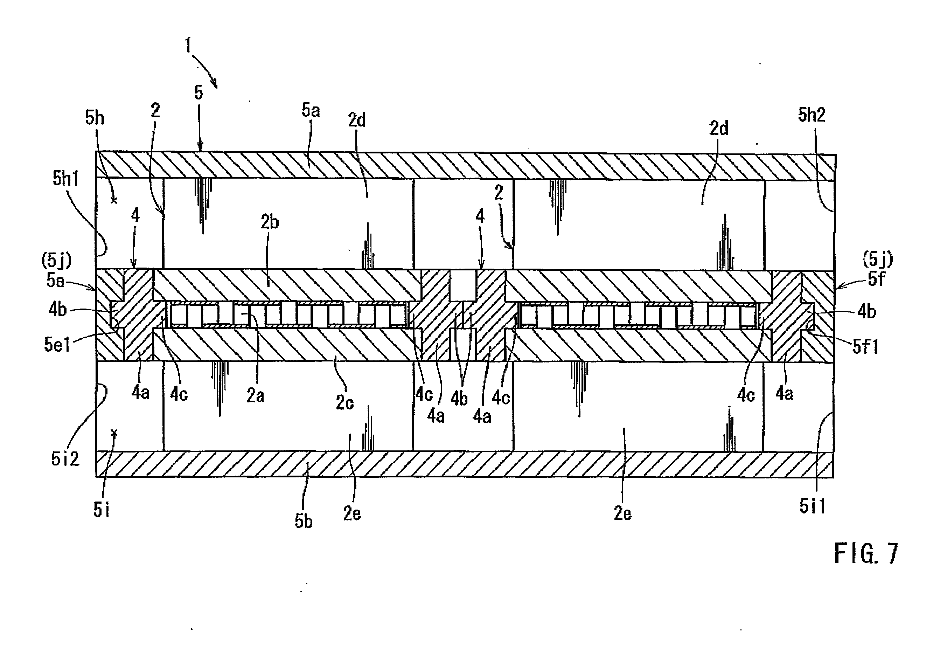

The thermoelectric conversion unit 1 may have a case 5 as shown in FIGS. 6 and 7 instead of the case 3 shown in FIG. 3. As shown in FIGS. 6 and 7, the case 5 may have a cylindrical shape and can be formed with an internal space in the case 5. The case 5 may include a top panel 5a, a bottom panel 5b, and side panels 5c and 5d. A front panel 5e is preferably provided between front portions of the side panels 5c and 5d, and a rear panel 5f is preferably provided between rear portions of the side panels 5c and 5d. The front panel Se and the rear panel 5f may be positioned between the top panel 5a and the bottom panel 5b.

As shown in FIG 6, depressed portions 5c1 and 5dl may be formed on inner side surfaces of the side panels 5c and 5d. The depressed portions 5c1 and 5dl are preferably generally positioned at the center of the height of the side panels 5c and 5d, and may be formed over the entire length of the side panels 5c and 5d in the longitudinal direction. As shown in FIG. 7, depressed portions 5el and 5fl may be formed on inner side surfaces of the front panel 5e and the rear panel 5f. The depressed portions 5el and 5fl are positioned at substantially the centers of the height of the front panel 5e and the rear panel 5f, and may be formed over the entire length of the front panel 5e and the rear panel 5f in the longitudinal direction.

As shown in FIG. 6, the thermoelectric conversion module 2 and the frame member 4 may be inserted into the case 5 from the front or rear of the case 5 such that the front panel 5e or the rear panel 5f can be removed. The frame member 4 may be inserted into the case 5 while the projecting portion 4b of the frame member 4 is guided into the depressed portions 5c1, and 5dl of the side panels 5c and 5d. As shown in FIG. 7, the two thermoelectric conversion modules 2 are preferably located adjacent to each other in the case 5. Further, the projecting portions 4b of the frame members 4 mounted on the respective thermoelectric conversion modules 2 preferably come into tight contact with each other.

As shown in FIGS. 6 and 7, the front panel 5e and the rear panel 5f may be mounted on the side panels 5c and 5d. The projecting portion 4b of the frame member 4 may be inserted into the depressed portion 5el of the front panel 5e and the depressed portion 5f1 of the rear panel 5f. The case 5 preferably includes a peripheral portion 5j (5c, 5d, 5e and 5f) configured to cover the outer peripheral portions of the frame members 4. The outer peripheral surfaces of the frame members 4 preferably come into tight contact with the peripheral wall portions 5j. Accordingly, the frame members 4 and the thermoelectric conversion modules 2 may form flow channels 5h and 5i in the internal space of the case 5.

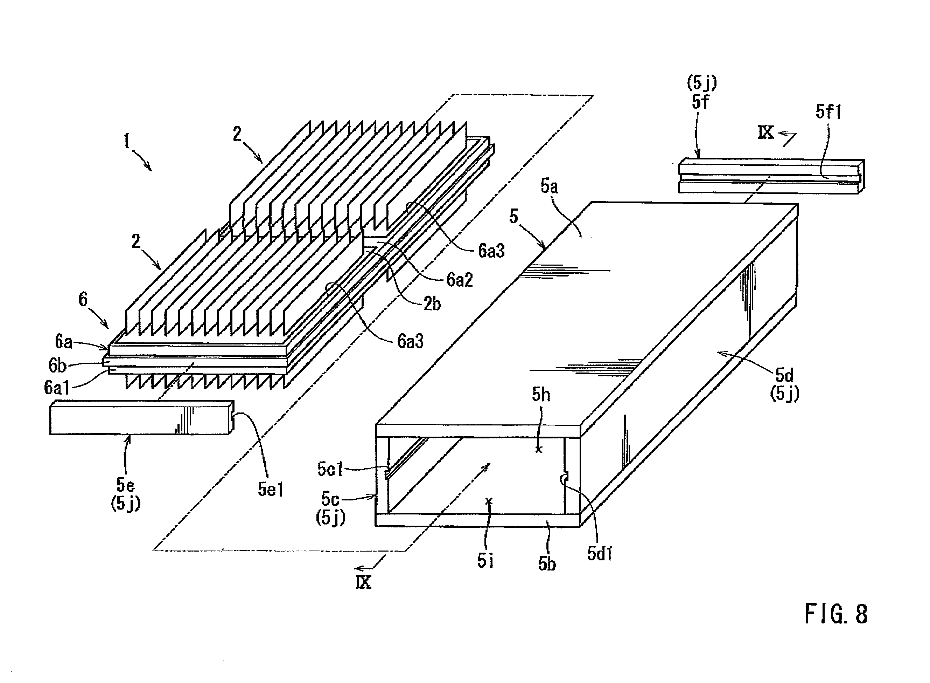

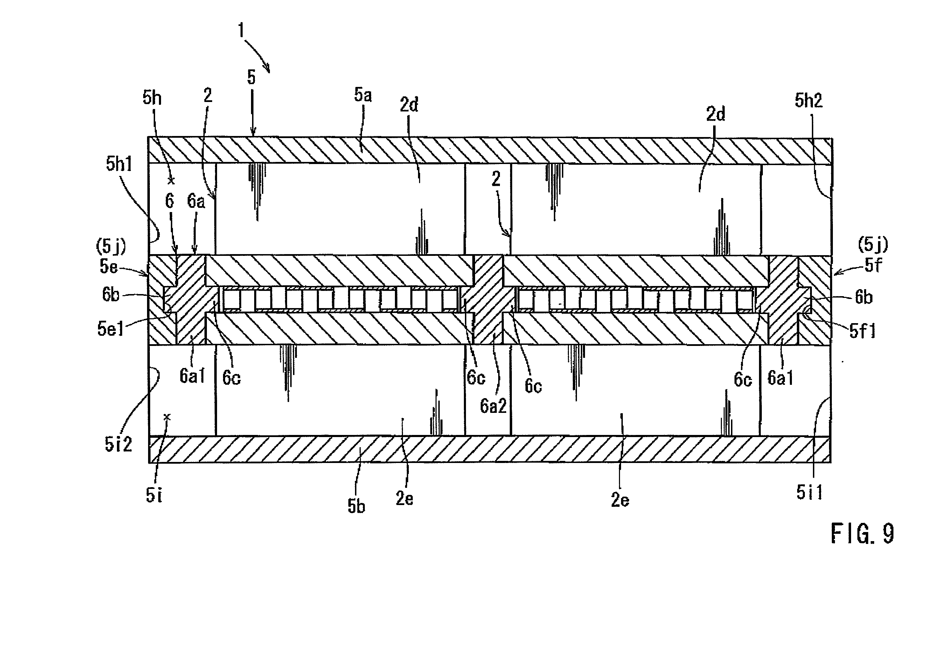

The thermoelectric conversion unit 1 may include a frame member 6 shown in FIGS. 8 and 9 instead of the frame member 4 shown in FIGS. 6 and 7. As shown in FIGS. 8 and 9, the frame member 6 may integrally include a frame body 6a, a projecting portion 6b, and an inner projecting portion 6c. The frame body 6a may include an annular outer frame portion 6al and a compartmentalizing portion 6a2 compartmentalizing an inner area of the outer frame portion 6al into a plurality of compartments.

The frame member 6 may be formed with a plurality of opening portions 6a3 by the outer frame portion 6a1 and the compartmentalizing portion 6a2. The respective thermoelectric conversion modules 2 may be mounted on the respective opening portions 6a3. An inner projecting portion 6c preferably projects between the substrates 2b and 2c from the frame body 6a. The inner projecting portions 6c are preferably formed on both surfaces, i.e., the inner peripheral surfaces of the outer same portion 6al and the compartmentalizing portion 6a2.

As shown in FIGS. 8 and 9, the projecting portion 6b may be inserted into the depressed portions 5c1 and 5d1 of the side panels 5c and 5d of the case 5 such that the front panel 5e or the rear panel Sf can be removed by a sliding movement. The front panel 5e and the rear panel 5f may be mounted on the front or rear portion of the case 5. The projecting portion 6b of the flame member 6 can be inserted into the depressed portions 5el and 5fl of the front panel 5e and the rear panel 5f. The frame member 6 preferably comes into tight contact with the circumference of the peripheral wall portion 5j (5c, 5d, 5e and 5f) of the case 5. Accordingly, the frame member 6 preferably forms the flow channels 5h and 5i in the internal space of the case 5 in cooperation with the thermoelectric conversion modules 2.

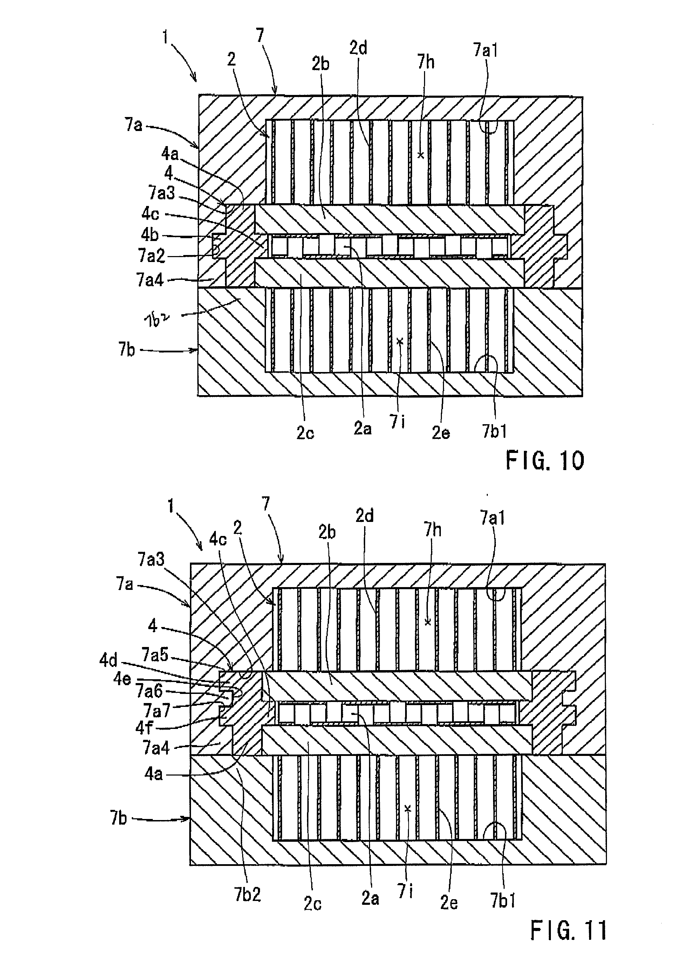

The thermoelectric conversion unit 1 may have a case 7 as shown in FIG. 10 instead of the case 3 shown in FIG. 5. The case 7 may include a first case 7a and a second case 7b as shown in FIG. 10. The first case 7a and the second case 7b are preferably stacked in layers and cooperate each other to configure a cylindrical shape. The cylindrical shape is similar to the cylindrical shape of the case 3 shown in FIGS. 3 to 5.

As shown in FIG. 10, depressed portions 7al and 7bl, which constitute flow channels 7h and 7i having an opened structure, may be formed on the first case 7a and the second case 7b. Opening portions of the flow channels 7h and 7i may be covered with the substrates 2b and 2c. The first case 7a may have a peripheral wall portion 7a4 configured to cover an outer periphery of the frame member 4. The peripheral wall portion 7a4 can be formed with a large depressed portion 7a3 and a depressed portion 7a2. The large depressed portion 7a3 is preferably formed over the entire length of a side wall of the first case 7a. The frame member 4 and outer peripheral end portions of the substrates 2b and 2c may be installed in the large depressed portion 7a3.

As shown in FIG. 10, the depressed portion 7a2 may be formed so as to be depressed on a bottom surface of the large depressed portion 7a3. The depressed portion 7a2 is preferably formed over the entire length of a side wall of the first case 7a. The projecting portion 4b of the frame member 4 may be inserted into the depressed portion 7a2. The frame member 4 can be mounted in the first case 7a using the projecting portion 4b and the depressed portion 7a2 by a sliding movement. The second case 7b may be placed on top of the first case 7a. The second case 7b may have an opposed wall portion 7b2 opposing the frame member 4 and a peripheral wall portion 7a4 on an outer periphery of the second flow channel 7i. Mounted on the first case 7a may be a front panel and a rear panel formed in the same manner as the front panel 5e and the rear panel 5f shown in FIG 6.

The thermoelectric conversion unit 1 may have the case 7 and the frame member 4 shown in FIG. 11 instead of the case 7 and the frame member 4 shown in FIG 10. The case 7 shown in FIG. 11 is not formed with the depressed portion 7a2 shown in FIG 10, but is formed with depressed portions 7a5 and 7a7 and a projecting portion 7a6. The depressed portions 7a5 and 7a7 are formed so as to be depressed on the bottom surface of the large depressed portion 7a3. The projecting portion 7a6 projects toward the frame member 4 from the bottom surface of the large depressed portion 7a3.

The frame member 4 shown in FIG 11 is not formed with the projecting portion 4b shown in FIG. 10 but is preferably formed with projecting portions 4d and 4f and a depressed portion 4e. The projecting portions 4d and 4f may be slidably inserted into the depressed portions 7a5 and 7a7 of the case 7. The projecting portion 7a6 of the case 7 may be slidably inserted into the depressed portion 4e. The frame member 4 can be mounted on the first case 7a using the projecting portions 4d, 4f and 7a6 and the depressed portions 4e, 7a5 and 7a7 via a sliding movement.

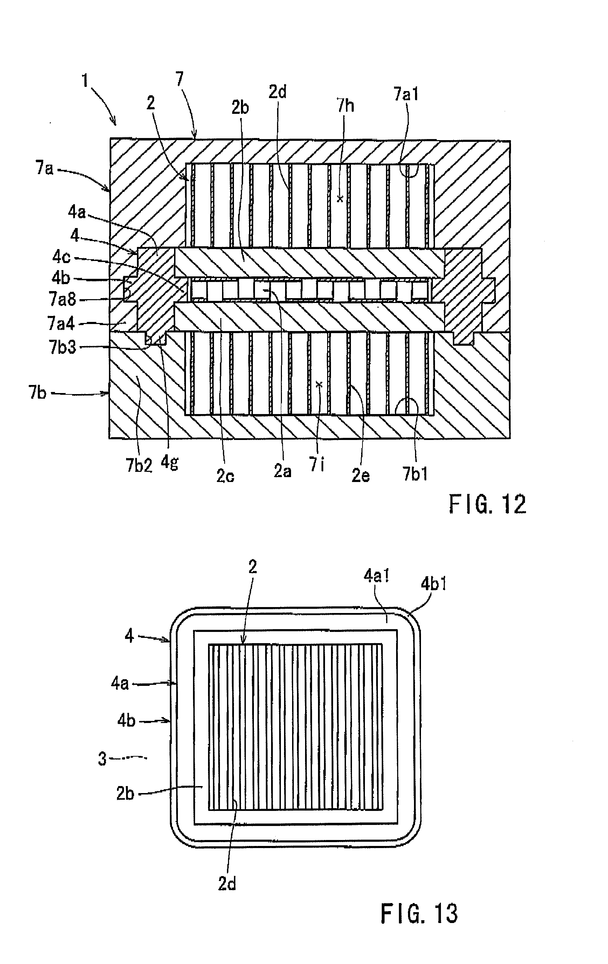

The thermoelectric conversion unit 1 may have the frame member 4 and the case 7 shown in FIG. 12 instead of the frame member 4 and the case 7 shown in FIG. 10. The frame member 4 shown in FIG 12 includes a sealing projecting portion 4g in addition to the configuration shown in FIG. 10. The opposed wall portion 7b2 of the second case 7b is formed with a depressed portion 7b3 in which the sealing projecting portion 4g is inserted. The sealing projecting portion 4g may come into resilient contact with the second case 7b by placing the second case 7b on the first case 7a. In such a way, the portion between the frame member 4 and the second case 7b may be sealed.

As described above and shown in FIG. 12, the case 7 preferably includes a first case 7a formed with a first flow channel 7h and a second case 7b formed with a second flow channel 7i. The first case 7a may have a peripheral wall portion 7a4. The second case 7b may have an opposed wall portion 7b2 opposing the peripheral wall portion 7a4 and the frame member 4. The frame member 4 may be provided with a sealing projecting portion 4g projecting toward the opposed wall portion 7b2 and configured to seal the portion between the frame member 4 and the opposed wall portion 7b2 by coming into resilient contact with the opposed wall portion 7b2. Therefore, the sealing projecting portion 4g can be resiliently deformed by placing the second case 7b on the first case 7a, and is capable of sealing the portion between the second case 7b and the frame member 4.

The frame member 4 may have four corners at substantially right angles as shown in FIG. 3, or may have arcuate portions 4al and 4bl as shown in FIG. 13. The arcuate portions 4al may be formed at the four corners of the frame body 4a. The arcuate portions 4bl are formed at four corners of the projecting portion 4b. The case 3 may be formed with arcuate portions having a shape corresponding to the arcuate portions 4al and 4bl of the frame member 4. Using such a construction, the four corners of the frame 4 are able to withstand concentrated forces applied to them. In this manner, the sealing property of the portion between the frame member 4 and the case 3 can be improved.

The thermoelectric conversion unit 1 may have any number of the thermoelectric conversion modules 2.

The case 3 may be formed with one or more flow channels. As shown in FIGS. 10 and 11, the case 7 may only have the first case 7a without having the second case 7b.

The thermoelectric conversion elements 2a may be Peltier elements providing a Peltier effect, or may be elements which provide a Seebeck Effect or a Thomson Effect.

A case 3 may be formed with the depressed portions 3c1 to 3g1 on the peripheral wall portion 3j and a frame member 4 may be formed with a projecting portion 4b. Alternatively, a case 3 may be formed without the depressed portions 3c1 to 3g1, and the frame member 4 may be formed without the depressed portions 3c1 to 3g1. The peripheral wall portion 3j of the case 3 and the outer peripheral portion of the frame member 4 may be brought into tight contact with each other to create a sealing effect.

As shown in FIG. 12, the sealing projecting portion 4g may be formed on the frame member 4. Alternatively, the seal projecting portion may be formed on the opposed wall portion 7b2 of the second case 7b. The frame member 4 may be formed with the depressed portion for allowing insertion of the seal projecting portion.

The heat exchange system 10 may be used for heating or cooling a cabin of the vehicle. When used for cooling, the first flow channel 3h is preferably connected to the piping 21 and the second flow channel 3i is preferably connected to the piping 22. The heat exchange system 10 may be used for cooling or heating vehicle components such as a battery. It is contemplated that the heat exchange system 10 may be used for heating and/or cooling objects and components outside of the vehicle industry.
Embodiments of the present invention may include a thermoelectric conversion unit (1) having a pair of substrates (2b, 2c) opposing each other, thermoelectric conversion element (2a)s provided between the pair of substrates (2b, 2c), a frame member (4; 6), and a case (3; 5; 7). The frame member (4; 6) may be mounted along an outer peripheral portion of the pair of substrates (2b, 2c). The case (3; 5; 7) may be formed with flow channel (3h, 3i; 5h, 5i, 7h, 7i)s having an opened structure. Opening portions of the flow channel (3h, 3i; 5h, 5i; 7h, 7i)s may be covered with the substrates (2b, 2c). The case (3; 5; 7) may include a peripheral wall portion (3j; 5j; 7a4) configured to cover the outer peripheral portion of the frame member (4; 6). The peripheral wall portion (3j; 5j; 7a4) of the case (3; 5; 7) and the outer peripheral portion of the frame member (4; 6) preferably tightly contact each other to achieve sealing.

## Claims

1. A thermoelectric conversion unit (1) comprising:
a pair of substrates (2b, 2c) opposing each other,
a thermoelectric conversion element (2a) provided between the pair of substrates (2b, 2c),
a frame member (4; 6) mounted along an outer peripheral portion of the pair of substrates (2b, 2c), and
a case (3; 5; 7) formed with a flow channel (3h, 3i; 5h, 5i; 7h, 7i) having an opened structure, and whose opening portion of the flow channel (3h, 3i; 5h, 5i; 7h, 7i) is covered with one of the substrates (2b, 2c),
wherein the case (3; 5; 7) comprises a peripheral wall portion (3j; 5j; 7a4) configured to cover the outer peripheral portion of the frame member (4; 6), wherein the peripheral wall portion (3j; 5j; 7a4) of the case (3; 5; 7) and the outer peripheral portion of the frame member (4; 6) contact each other to achieve sealing.

2. A thermoelectric conversion unit (1) as in claim 1, wherein the frame member (4; 6) comprises an inner peripheral portion which contacts the entire circumferences of the respective outer peripheral portions of the pair of substrates (2b, 2c), and an outer peripheral portion which contacts the entire circumference of the peripheral wall portion (3j; 5j; 7a4) of the case (3; 5; 7).

3. A thermoelectric conversion unit (1) as in claim 1 or 2, further comprising a depressed portion (3cl-3gl; 4e; 5cl-5fl; 7a5, 7a7) wherein the depressed portion (3cl-3gl; 4e; 5cl-5fl; 7a5, 7a7) is formed either of the peripheral wall portion (3j; 5j; 7a4) of the case (3; 5; 7) or the outer peripheral portion of the frame member (4; 6), and a projecting portion (4b, 4d, 4f; 6b; 7a6) wherein the projecting portion (4b, 4d, 4f; 6b; 7a6) is formed either of the peripheral wall portion (3j; Sj; 7a4) of the case (3; 5; 7) or the outer peripheral portion of the frame member (4; 6), and wherein the projecting portion (4b, 4d, 4f; 6b; 7a6) may be inserted into the depressed portion (3cl-3gl; 4e; 5cl-5fl; 7a5, 7a7).

4. A thermoelectric conversion unit (1) as in claim 3,
wherein the case (3; 5; 7) is provided with a tubular member,
wherein the tubular member is formed with opening portions at both ends thereof, wherein formed on the inner peripheral portion of the tubular member is either the depressed portion (3c1-3g1; 4e; 5c1-5f1; 7a5, 7a7) or projecting portion (4b, 4d, 4f; 6b; 7a6), such portion extending in an axial direction of the tubular member, wherein such portion extends to both opening portions of the tubular member.

5. A thermoelectric conversion unit (1) as in one of claims 1 to 4, further comprising:
an internal space configured in the case (3; 5; 7) to store the pair of substrates (2b, 2c) and the frame member (4; 6),
a first flow channel (3h; 5h; 7h) created in the internal space by the frame member (4; 6) and one of the substrates (2b, 2c), and
a second flow channel (3i; 5i; 7i) created in the internal space by the frame member (4; 6) and the other of the substrates (2b, 2c).

6. A thermoelectric conversion unit (1) as in one of claims 1 to 5,
wherein the case (7) comprises a first case (7a) formed with a first flow channel (7h) and a second case (7b) formed with a second flow channel (7i),
wherein the second case (7b) comprises an opposed wall portion (7b2) opposing the frame member (4),
wherein either the frame member (4) or the opposed wall portion (7b2) is provided with a sealing projecting portion (4g), the sealing projecting portion (4g) configured to seal the frame member (4) and the opposed wall portion (7b2), such that the frame member (4) and the opposed wall portion (7b2) come into resilient contact with each other.
